# EUROPEAN PATENT APPLICATION

(11) **EP 4 779 639 A1**
(43) Date of publication of application: **22.07.2026**
(21) Application number: 25211292.5
(22) Date of filing: 27.10.2025
(51) Int. Cl.: G11C 11/406

(54) **MEMORY SUPPORTING FREQUENCY SETTING AND OPERATION METHOD OF MEMORY**

(30) Priority: 21.01.2025 KR 20250008687
(71) Applicant: SK hynix Inc., Bubal-eub Icheon-si Gyeonggi-do 17336 (KR)
(72) Inventor: KIM, Min O, 17336 Icheon-si (KR); YOU, Jung Taek, 17336 Icheon-si (KR); KWON, Han Byeol, 17336 Icheon-si (KR); KIM, Kyu Young, 17336 Icheon-si (KR)
(74) Representative: Isarpatent

(57) **Abstract**

A memory includes a setting information storage circuit configured to store various setting information, a frequency setting change detection circuit configured to detect a change in a frequency setting stored in the setting information storage circuit, and an internal command generation circuit configured to activate a low power mode signal when the change in the frequency setting is detected.

## Description

### CROSS-REFERENCE TO RELATED APPLICATION(S)

This application claims priority under 35 U.S.C. §119 to Korean Patent Application No. 10-2025-0008687, filed on January 21, 2025, the disclosure of which is incorporated herein by reference in its entirety.

### BACKGROUND

### 1. Technical Field

Various embodiments of the present disclosure relate to a memory.

### 2. Related Art

Various integrated circuit devices may operate in synchronization with a clock signal and support operation at various frequencies. Memories may also operate in synchronization with a clock signal, and although a frequency of the clock signal is sometimes fixed, the frequency of the clock signal may change to increase performance or reduce current consumption of the memories during operation.

### SUMMARY

In accordance with an embodiment of the present disclosure, a memory may include a setting information storage circuit configured to store various setting information; a frequency setting change detection circuit configured to detect a change in frequency setting stored in the setting information storage circuit; and an internal command generation circuit configured to activate a low power mode signal when the change in the frequency setting is detected.

In accordance with an embodiment of the present disclosure, an operation method of a memory may include externally receiving a setting command and a frequency setting value; storing the frequency setting value in a setting information storage circuit; determining whether the frequency setting value stored in the setting information storage circuit is different from a previous frequency setting value; and activating a low power mode signal in response to a determination that the frequency setting value is different from the previous frequency setting value.

In accordance with an embodiment of the present disclosure, a memory may include a mode register set circuit configured to store various setting information; a frequency setting change detection circuit configured to detect a change in a frequency set point setting stored in the mode register set circuit; and an internal command generation circuit configured to activate a low power mode signal when the change in the frequency set point setting is detected.

### BRIEF DESCRIPTION OF THE DRAWINGS

FIG. 1 is a block diagram illustrating a memory in accordance with an embodiment of the present disclosure.
FIG. 2 is a block diagram illustrating a frequency setting change detection circuit illustrated in FIG. 1.
FIG. 3 is a block diagram illustrating an internal command generation circuit illustrated in FIG. 1.
FIG. 4 is a block diagram illustrating another embodiment of an internal command generation circuit illustrated in FIG. 1.

### DETAILED DESCRIPTION

Various embodiments of the present disclosure are directed to technology of reducing current consumption occurring during a process of changing an operating frequency of a memory.

According to embodiments of the present disclosure, it is possible to reduce current consumption occurring during a process of changing an operating frequency of a memory.

Hereinafter, various embodiments according to the technical spirit of the present disclosure are described below with reference to the accompanying drawings.

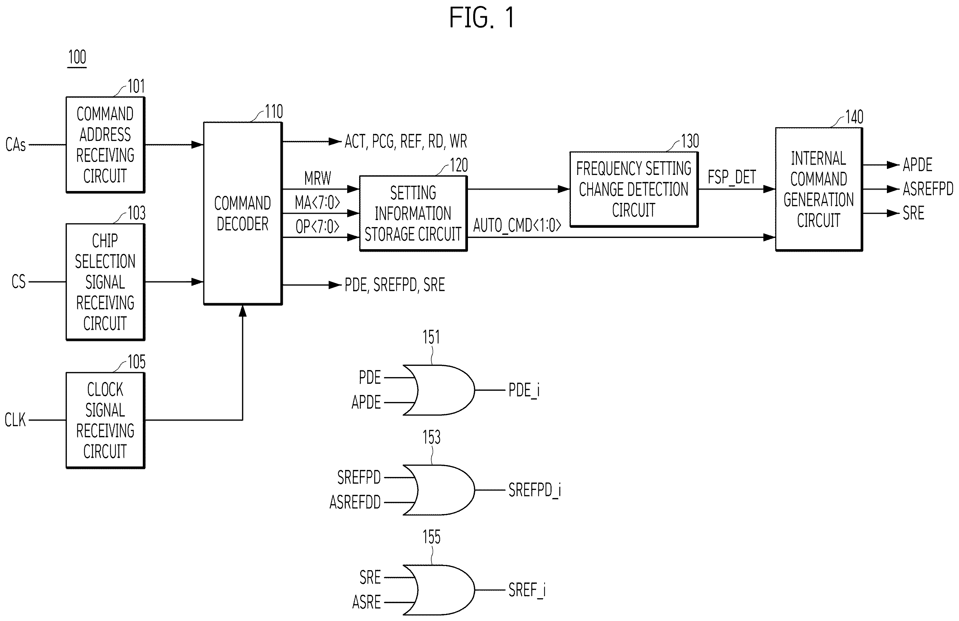

FIG. 1 is a block diagram illustrating a memory 100 in accordance with an embodiment of the present disclosure. FIG. 1 illustrates configurations for receiving control signals in the memory 100 and configurations related to controlling the memory 100.

Referring to FIG. 1, the memory 100 may include a command address receiving circuit 101, a chip selection signal receiving circuit 103, a clock signal receiving circuit 105, a command decoder 110, a setting information storage circuit 120, a frequency setting change detection circuit 130, and an internal command generation circuit 140.

The command address receiving circuit 101 may receive a plurality of command address signals CAs from a memory controller (i.e., an external device). The chip selection signal receiving circuit 103 may receive a chip selection signal CS from the memory controller, and the clock signal receiving circuit 105 may receive a clock signal CLK from the memory controller.

The command decoder 110 may operate in synchronization with the clock signal CLK. The command decoder 110 may decode the command address signals CAs and the chip selection signal CS to detect an operation instructed by the memory controller to the memory 100 and generate signals accordingly. An active signal ACT may be a signal instructing an active operation, a pre-charge signal PCG may be a signal instructing a pre-charge operation, and a refresh signal REF may be a signal instructing a refresh operation. A read signal RD may be a signal instructing a read operation, and a write signal WR may be a signal instructing a write operation.

A setting signal MRW generated by the command decoder 110 may be a signal instructing a setting operation, a setting type signal MA<7:0> may be a signal designating one of various setting items, and a setting value signal OP<7:0> may be a signal indicating a setting value of an item selected by the setting type signal MA<7:0>. The setting signal MRW may be referred to as a "mode register write signal", the setting type signal MA<7:0> may be referred to as a "mode register address", and the setting value signal OP<7:0> may be referred to as an "operation code".

In addition, the command decoder 110 may generate signals that controls the memory 100 to a low power mode, i.e., low power mode signals PDE, SREFPD and SRE, according to a result of a decoding operation. A power down mode signal PDE is a signal that controls the memory 100 to a power down mode. A self-refresh power down mode signal SREFPD is a signal that controls the memory 100 to a self-refresh power down mode. In the self-refresh power down mode, most configurations of the memory 100 may be switched to a power down mode state, but data stored in the memory 100 may be retained through a self-refresh operation. A self-refresh mode signal SRE is a signal that controls the memory 100 to a self-refresh mode. In the self-refresh mode, the self-refresh operation may be performed to retain the data stored in the memory 100. The power down mode is a mode that consumes the least power, and the self-refresh power down mode consumes more power than the power down mode but less power than the self-refresh mode. In addition, the self-refresh mode consumes more power than the power-down mode and the self-refresh power down mode but is a low power mode that consumes less power than a normal mode.

The setting information storage circuit 120 may store various setting information. The setting information storage circuit 120 may set setting items determined by the setting type signal MA<7:0> to values of the setting value signal OP<7:0> when the setting signal MRW is activated. The setting information storage circuit 120 may be referred to as a "mode register set circuit". The setting items of the setting information storage circuit 120 may include various voltage level setting values, timing parameter setting values, and operating frequency setting values of the inside of the memory 100.

Frequency setting bits FSP<2:0> illustrated in the drawing represent the frequency setting values stored in the setting information storage circuit 120. The memory 100 needs frequency-specific setting values to operate at various frequencies, and for this purpose, a frequency set point (FSP) setting is used. The frequency set point setting refers to a function that allows settings optimized for each frequency to be designated in advance and various settings of the memory 100 to be changed at once by changing a value of the frequency setting bits FSP<2:0>. For example, when the value of the frequency setting bits FSP<2:0> is 0, the memory 100 may be configured with setting values that are optimized when a frequency of the clock signal CLK is 500 MHz. When the value of the frequency setting bits FSP<2:0> is 1, the memory 100 may be configured with setting values that are optimized when the frequency of the clock signal CLK is 1 GHz. When the value of the frequency setting bits FSP<2:0> is 2, the memory 100 may be configured with setting values that are optimized when the frequency of the clock signal CLK is 1.5 GHz. In addition, auto command setting bits AUTO_CMD<1:0> illustrated in the drawing are bits that set an operation of the internal command generation circuit 140, which is to be described later.

The frequency setting change detection circuit 130 may detect a change in the frequency setting stored in the setting information storage circuit 120. The frequency setting change detection circuit 130 may detect a change in a value of the frequency setting bits FSP<2:0>. When the change is detected, the frequency setting change detection circuit 130 may activate a frequency setting change signal FSP_DET.

The internal command generation circuit 140 may activate one of low power mode signals APDE, ASREFPD and ASRE when the frequency setting change signal FSP_DET is activated. The activation of the frequency setting change signal FSP_DET represents that the frequency of the clock signal CLK transmitted from the memory controller is changed, and consequently, the memory 100 has to adjust operational settings to setting values optimized for the changed frequency. The change in the frequency of the clock signal CLK takes a considerable amount of time, and during this time, the memory controller may not transmit signals such as a command address to the memory 100, and the memory 100 also may not receive the signals from the memory controller. The internal command generation circuit 140 may enable the memory 100 to operate in the low power mode during a period where it is impossible to transmit and receive the signals according to the change in the frequency of the clock signal CLK, thereby reducing current consumption of the memory 100.

The internal command generation circuit 140 may be set by the auto command setting bits AUTO_CMD<1:0>, and the auto command setting bits AUTO_CMD<1:0> may include auto command generation activation information and low power mode selection information. The auto command generation activation information may be information that controls activation and deactivation of the internal command generation circuit 140. When the internal command generation circuit 140 is deactivated by the auto command generation activation information, the internal command generation circuit 140 may not activate one of the low power mode signals APDE, ASREFPD and ASRE even though the frequency setting change signal FSP_DET is activated. The low power mode selection information may be information that selects which of the low power mode signals APDE, ASREFPD and ASRE to activate when the frequency setting change signal FSP_DET is activated.

A power down mode signal APDE generated by the internal command generation circuit 140 does the same with the power down mode signal PDE generated by the command decoder 110. However, there may be a difference in that the power down mode signal APDE is activated in response to the activation of the frequency setting change signal FSP_DET, and the power down mode signal PDE is activated as a result of decoding the signals transmitted from the memory controller. The memory 100 may be controlled in the power down mode by an output signal PDE_i of an OR gate 151 that receives the two power down mode signals PDE and APDE. Likewise, a self-refresh power down mode signal ASREFPD generated by the internal command generation circuit 140 may do the same with the self-refresh power-down mode signal SREFPD generated by the command decoder 110, and a self-refresh mode signal ASRE generated by the internal command generation circuit 140 may do the same with the self-refresh mode signal SRE generated by the command decoder 110. The memory 100 may be controlled in the self-refresh power down mode by an output signal SREFPD_i of an OR gate 153 and be controlled in the self-refresh mode by an output signal SREF_i of an OR gate 155.

Although it is described according to an embodiment that the internal command generation circuit 140 activates one of the low power mode signals APDE, ASREFPD and ASRE according to the low power mode selection information, it is also possible for the internal command generation circuit 140 to fixedly activate a specific low power mode signal. For example, the internal command generation circuit 140 may activate the self-refresh power down mode signal ASREFPD at all times when the frequency setting change signal FSP_DET is activated.

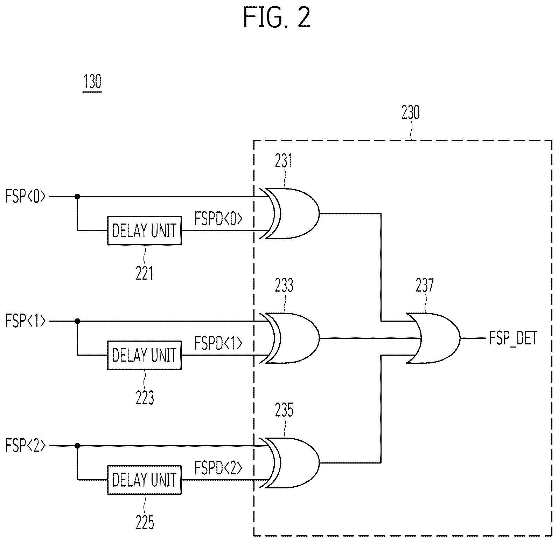

FIG. 2 is a block diagram illustrating the frequency setting change detection circuit 130 illustrated in FIG. 1.

Referring to FIG. 2, the frequency setting change detection circuit 130 may include delay units (i.e., delay components or delay circuits) 221, 223 and 225 and a comparison unit (i.e., a comparison component or a comparison circuit) 230.

The delay unit 221 may delay the frequency setting bit FSP<0>, the delay unit 223 may delay the frequency setting bit FSP<1>, and the delay unit 225 may delay the frequency setting bit FSP<2>.

The comparison unit 230 may compare the frequency setting bits FSP<2:0> with frequency setting bits FSPD<2:0> obtained by delaying the frequency setting bits FSP<2:0> by the delay units 221, 223 and 225, and activate the frequency setting change signal FSP_DET when a bit having a different value is present. The comparison unit 230 may include XOR gates (i.e., exclusive OR gates) 231, 233 and 235 and an OR gate 237.

The XOR gate 231 may output an output signal as "1" when the frequency setting bit FSP<0> and the frequency setting bit FSPD<0> have different values, and output the output signal as "0" otherwise. The XOR gate 233 may output an output signal as "1" when the frequency setting bit FSP<1> and the frequency setting bit FSPD<1> have different values, and output the output signal as "0" otherwise. The XOR gate 235 may output an output signal as "1" when the frequency setting bit FSP<2> and the frequency setting bit FSPD<2> have different values, and output the output signal as "0" otherwise. The output signals of the XOR gates 231, 233 and 235 being "1" may represent that the corresponding frequency setting bit has been changed. The OR gate 237 may receive the output of the XOR gates 231, 233 and 235 and output the frequency setting change signal FSP_DET. Consequently, the frequency setting change signal FSP_DET may be a signal that is activated when one or more values of the frequency setting bits FSP<2:0> are changed.

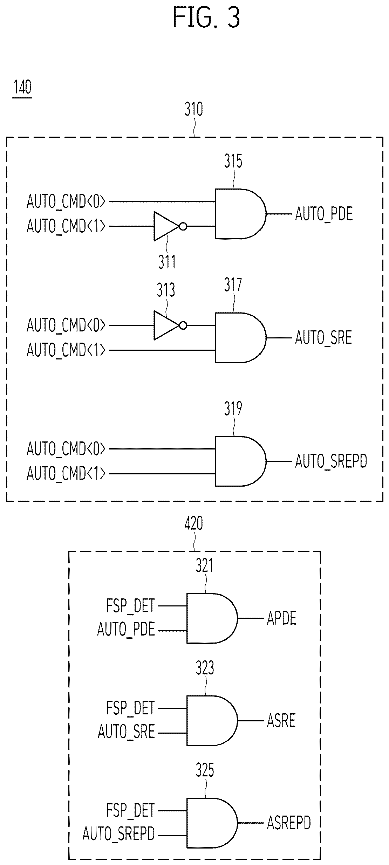

FIG. 3 is a block diagram illustrating the internal command generation circuit 140 illustrated in FIG. 1.

Referring to FIG. 3, the internal command generation circuit 140 may include a setting unit (i.e., a setting component or a setting circuit) 310 and a command generation unit (i.e., a command generation component or a command generation circuit) 320.

The setting unit 310 may set the internal command generation circuit 140 using the auto command setting bits AUTO_CMD<1:0>. The setting unit 310 may include inverters 311 and 313 and AND gates 315, 317 and 319. An operation of the setting unit 310 according to values of the auto command setting bits AUTO_CMD<1:0> is summarized in Table 1 below.

**[Table 1]**

| AUTO_CMD<1:0> | Signal to Be Activated | Set Operation |
|---|---|---|
| 00 | (None) | Internal command generation circuit is deactivated |
| 01 | AUTO_PDE | APDE is activated when FSP_DET is activated |
| 10 | AUTO_SRE | ASRE is activated when FSP_DET is activated |
| 11 | AUTO_SREFPD | ASREFPD is activated when FSP_DET is activated |

The command generation unit 320 may activate a set signal among the low power mode signals APDE, ASREFPD and ASRE when the frequency setting change signal FSP_DET is activated. The command generation unit 320 may include AND gates 321, 323 and 325.

When the auto command setting bits AUTO_CMD< 1:0> are "00", none of the low power mode signals APDE, ASREFPD and ASRE are activated even though the frequency setting change signal FSP_DET is activated. In a case that the auto command setting bits AUTO_CMD<1:0> are "01" and a signal AUTO_PDE is activated, the power down signal APDE is activated by the AND gate 321 when the frequency setting change signal FSP_DET is activated. In a case that the command setting bits AUTO_CMD<1:0> are "10" and a signal AUTO_SRE is activated, the power down mode signal ASRE is activated by the AND gate 323 when the frequency setting change signal FSP_DET is activated. In a case that the auto command setting bits AUTO_CMD<1:0> are "11" and a signal AUTO_SREFPD is activated, the self-refresh power down mode signal ASREFPD is activated by the AND gate 325 when the frequency setting change signal FSP_DET is activated.

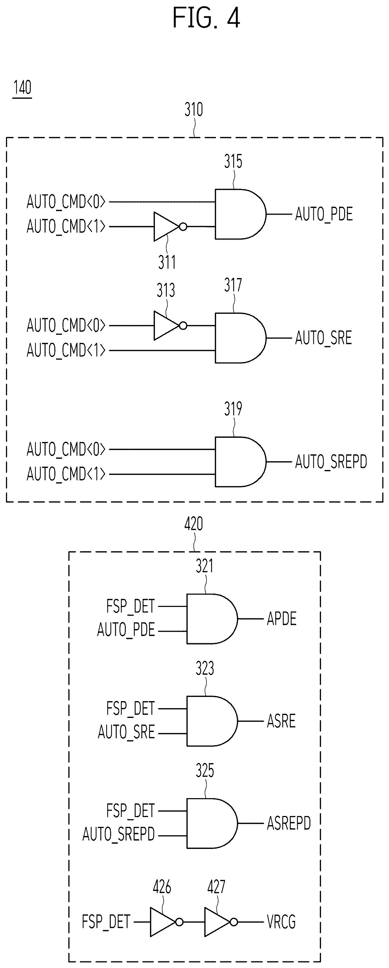

FIG. 4 is a block diagram illustrating another embodiment of the internal command generation circuit 140 illustrated in FIG. 1.

The internal command generation circuit 140 illustrated in FIG. 4 may include a command generation unit (i.e., a command generation component or a command generation circuit) 420 having a different configuration from the command generation unit 320 illustrated in Fig. 3.

The command generation unit 420 may activate a set signal among the low power mode signals APDE, ASREFPD and ASRE when the frequency setting change signal FSP_DET is activated. In addition, the command generation unit 420 may activate a reference voltage (Vref) current generator (VRCG) mode signal VRCG in response to the activation of the frequency setting change signal FSP_DET. The command generation unit 420 may include AND gates 321, 323 and 325 and inverters 426 and 427.

When the auto command setting bits AUTO_CMD< 1:0> are "00", none of the low power mode signals APDE, ASREFPD and ASRE are activated even though the frequency setting change signal FSP_DET is activated. In a case that the auto command setting bits AUTO_CMD<1:0> are "01" and a signal AUTO_PDE is activated, the power down signal APDE is activated by the AND gate 321 when the frequency setting change signal FSP_DET is activated. In a case that the auto command setting bits AUTO_CMD<1:0> are "10" and a signal AUTO_SRE is activated, the power down mode signal ASRE is activated by the AND gate 323 when the frequency setting change signal FSP_DET is activated. In a case that the auto command setting bits AUTO_CMD<1:0> are "11" and a signal AUTO_SREFPD is activated, the self-refresh power down mode signal ASREFPD is activated by the AND gate 325 when the frequency setting change signal FSP_DET is activated.

The command generation unit 420 may activate the VRCG mode signal VRCG in response to the activation of the frequency setting change signal FSP_DET. When the VRCG mode signal VRCG is activated, a VRCG mode is activated for a predetermined period of time. The VRCG mode may be a mode that increases an amount of current supplied to a reference voltage generator in order to reduce setting time taken when changing levels of various reference voltages used by the memory 100 to receive the command address signals CAs, the chip selection signal CS and data. When a frequency of the memory 100 is changed, the levels of the reference voltages have to also be changed. Therefore, when a change in the frequency setting is detected, the VRCG mode may be activated so that the levels of the reference voltages may be quickly changed.

Although not illustrated, the command generation unit 420 may further activate internal command signals that instruct an operation of the memory 100 operable during the low power mode in response to the activation of the frequency setting change signal FSP_DET. The internal command signals may include various signals such as an all bank refresh command signal and an all bank refresh management (RFM) command signal.

Furthermore, an operation method of a memory in accordance with an embodiment of the present disclosure may include externally receiving a setting command and a frequency setting value; storing the frequency setting value in a setting information storage circuit; determining whether the frequency setting value stored in the setting information storage circuit is different from a previous frequency setting value; and activating a low power mode signal in response to a determination that the frequency setting value is different from the previous frequency setting value.

According to embodiments of the present disclosure, current consumption occurring during a process of changing an operating frequency of a memory can be reduced.

Although the technical spirit of the present disclosure has been described above according to embodiments, this is only for describing the embodiments according to the concept of the present disclosure, and the present disclosure is not limited to the above embodiments. Various embodiments may be applied by those skilled in the art, to which the present disclosure pertains, within the scope of the technical spirit of the present disclosure. Furthermore, the embodiments may be combined to form additional embodiments.

## Claims

1. A memory comprising:
a setting information storage circuit configured to store various setting information;
a frequency setting change detection circuit configured to detect a change in a frequency setting stored in the setting information storage circuit; and
an internal command generation circuit configured to activate a low power mode signal when the change in the frequency setting is detected.

2. The memory of claim 1, wherein the low power mode signal is one of a power down mode signal, a self-refresh mode signal and a self-refresh power down mode signal.

3. The memory of claim 1, wherein:
the setting information storage circuit stores auto command generation activation information; and
the internal command generation circuit is activated or deactivated according to the auto command generation activation information.

4. The memory of claim 3, wherein:
the setting information storage circuit stores low power mode selection information, and
one of a power down mode signal, a self-refresh mod signal and a self-refresh power down mode signal is selected as the low power mode signal according to the low power mode selection information.

5. The memory of claim 1, wherein the frequency setting change detection circuit detects the change in the frequency setting by detecting a change in values of frequency setting bits stored in the setting information storage circuit.

6. The memory of claim 1, wherein the frequency setting change detection circuit includes:
delay circuits configured to delay frequency setting bits stored in the setting information storage circuit; and
a comparison circuit configured to compare the frequency setting bits stored in the setting information storage circuit with frequency setting bits delayed by the delay circuits, and activate a frequency setting change signal when a bit having a different level is present.

7. The memory of claim 1, wherein the internal command generation circuit further activates a reference voltage current generator mode signal, along with activation of the low power mode signal.

8. The memory of claim 1, wherein the internal command generation circuit further activates an internal command signal that instructs an operation of the memory operable during a low power mode, along with activation of the low power mode signal.

9. An operation method of a memory, the operation method comprising:
externally receiving a setting command and a frequency setting value;
storing the frequency setting value in a setting information storage circuit;
determining whether the frequency setting value stored in the setting information storage circuit is different from a previous frequency setting value; and
activating a low power mode signal in response to a determination that the frequency setting value is different from the previous frequency setting value.

10. The operation method of claim 9, wherein the low power mode signal is one of a power down mode signal, a self-refresh mode signal and a self-refresh power down mode signal.

11. The operation method of claim 9, wherein the determining whether the frequency setting value stored in the setting information storage circuit is different from the previous frequency setting value includes detecting a change in values of frequency setting bits stored in the setting information storage circuit.

12. The operation method of claim 9, wherein activating the low power mode signal includes selecting and activating, as the low power mode signal, one of a power down mode signal, a self-refresh mode signal and a self-refresh power down mode signal according to low power mode selection information.

13. The operation method of claim 9, further comprising activating a reference voltage current generator mode signal in response to the determination.

14. The operation method of claim 9, further comprising activating an internal command signal that instructs an operation of the memory operable during a low power mode in response to the determination.

15. A memory comprising:
a mode register set circuit configured to store various setting information;
a frequency setting change detection circuit configured to detect a change in a frequency set point setting stored in the mode register set circuit; and
an internal command generation circuit configured to activate a low power mode signal when the change in the frequency set point setting is detected.
